# FASCICULE DE BREVET EUROPEEN

(11) **EP 1 142 023 B1**
(45) Date de publication et mention de la délivrance du brevet: **22.06.2011**
(21) Numéro de dépôt: 99958326.3
(22) Date de dépôt: 14.12.1999
(51) Int. Cl.: H01L 29/06, H01L 29/41

(54) **Structure périphérique pour dispositif monolithique de puissance**
Randstruktur für monolithische Leistungsanordnung
Peripheral structure for monolithic power device

(30) Priorité: 18.12.1998 FR 9816060
(43) Date de publication de la demande: 10.10.2001
(73) Titulaire: CENTRE NATIONAL DE LA RECHERCHE SCIENTIFIQUE, 75016 Paris Cédex (FR)
(72) Inventeur: AUSTIN, Patrick, F-31240 l'Union (FR); SANCHEZ, Jean-Louis, F-31750 Escalquens (FR); CAUSSE, Olivier, F-12850 Onet le Château (FR); BREIL, Marie, F-31400 Toulouse (FR); LAUR, Jean-Pierre, F-81000 Albi (FR); JALADE, Jean, F-31320 Castanet-Tolosan (FR)
(74) Mandataire: Michelet, Alain
(86) Numéro de dépôt international: PCT/FR1999/003134
(87) Numéro de publication internationale: WO 2000/038243

(56) Documents cités:
- EP-A- 0 521 558
- EP-A- 0 818 825
- EP-A- 0 821 411
- WO-A-83/00582
- US-A- 3 795 846
- US-A- 5 608 237
- AUSTIN ET AL: "Optimization of PP- junction termination for new power devices" SOLID-STATE ELECTRONICS, vol. 39, no. 4, avril 1996 (1996-04), pages 593-599, ELSEVIER SCIENCE PUBLISHERS, BARKING, GB
- WU ET AL: "Analysis of the FP-JTE planar junction termination" SOLID STATE ELECTRONICS, vol. 42, no. 11, novembre 1998 (1998-11), pages 2097-2100, ELSEVIER SCIENCE PUBLISHERS, BARKING, GB

## Description

La présente invention se rapporte à une structure périphérique pour dispositif monolithique de puissance.

Les circuits intégrés traditionnels se différencient habituellement par le dessin (layout) de masques. Ils sont ainsi verticalement figés et donc peu adaptés à une évolution d'intégration de puissance. C'est pourquoi, pour créer de nouvelles fonctions de puissance, on utilise préférentiellement des structures constituées de briques technologiques compatibles entre elles.

On connaît ainsi des composants intégrés monolithiques de puissance en technologie planar. Il est essentiel que de tels composants aient une bonne tenue en tension, c'est-à-dire qu'ils disposent d'un champ électrique maximum avant claquage par avalanche qui soit suffisamment élevé pour supporter les tensions désirées, tout en restant inférieur au champ électrique critique. Le champ électrique maximum doit être maîtrisable lors de la conception et de la fabrication du composant.

Cette maîtrise repose pour l'ensemble des dispositifs de puissance semi-conducteurs connus sur des solutions dites « de garde », fondées sur un étalement de lignes équipotentielles à la surface du composant et aux niveaux de jonctions.

Ainsi, des techniques de type mesa consistent à réaliser de façon mécanique un biseautage au niveau d'une jonction à protéger. Cependant, ces techniques sont difficilement compatibles avec des procédés planar permettant la réalisation de dispositifs de puissance complexes intégrés. De plus, elle exclut des procédés à technologies MOS, telles que des technologies MOS-bipolaires IGBT (Insulated Gate Bipolar Transistor) ou MOS-thyristors MCT (MOS Controlled Thyristor).

D'autres techniques de garde mettent en oeuvre des anneaux de garde, des électrodes de champ ou plaques de champ, des couches semi-résistives ou des terminaisons de jonctions P- (JTE - Junction Termination Extension). La technique de type terminaison de jonction, notamment, consiste en une implantation d'une région faiblement dopée P- tout autour d'une jonction principale à protéger et en contact avec elle. Les composants intégrés utilisant ces différentes techniques de garde comprennent généralement des caissons d'isolation formés latéralement dans le composant et ayant une partie centrale rétrécie, ainsi qu'un canal d'arrêt des lignes de potentiels (stop channel) réalisé entre la jonction principale et l'une des diffusions du caisson d'isolation.

Un inconvénient de ces techniques de garde est qu'elles requièrent une surface minimale pour pouvoir maîtriser le champ électrique maximum. De plus, la fabrication est compliquée par la nécessité d'implanter un canal d'arrêt. Les composants qui utilisent ces techniques de garde, ont par ailleurs une tenue en tension dissymétrique et constituent donc des briques technologiques de portée réduite.

En particulier, certains dispositifs possèdent une jonction en face arrière, physiquement connectée à des caissons d'isolation latéraux, et une jonction en face avant, protégée par une des techniques de garde et encadrée latéralement par des stop-channels. Lorsque la jonction avant est polarisée en inverse, les lignes équipotentielles sont bloquées au niveau des stop-channels et n'atteignent pas les caissons d'isolation, tandis que lorsque la jonction arrière est polarisée en inverse, les lignes équipotentielles remontent vers la face avant à travers les caissons d'isolation.

Outre les inconvénients précités, cette réalisation ne permet d'introduire que des fonctions électriques élémentaires dans le caisson défini par la jonction arrière. De telles structures périphériques sont connues par exemple des documents EP-A-0 821 411, EP-A-0 521 558,
US-A-3 795 846 et Solid State Electronics, vol.39, N° 4, avril 1996, pages 593-599 et vol. 42, N° 11, novembre 1998, pages 2097-2100.

La présente invention concerne une structure périphérique pour dispositif monolithique de puissance ayant un encombrement plus faible que les composants connus à valeur égale du champ électrique critique et rendant possible l'implantation de fonctions électriques à la fois en face avant et en face arrière.

La structure de l'invention est compatible avec une technologie planar, et permet une bonne maîtrise du champ électrique.

L'invention a également pour objet une telle structure périphérique ne requérant pas de canal d'arrêt et utilisable avec une technologie MOS.

La structure périphérique selon l'invention peut également permettre de supporter des tensions symétriques, et être ainsi particulièrement souple d'utilisation en tant que brique technologique. Cette brique permet la symétrisation en tension de composants de puissance existants, tels que des transistors bipolaires de puissance, des thyristors ou des composants IGBT, mais aussi la conception et la réalisation de nouveaux composants ou de nouvelles fonctions électriques de puissance.

A cet effet, l'invention a pour objet une structure périphérique pour dispositif monolithique de puissance selon la revendication 1. Des réalisations particulières sont couvertes par les revendications dépendantes.

La structure comprend:
- un substrat ayant un premier type de dopage,
- une face avant munie d'une connexion à une cathode,
- une face arrière munie d'une connexion à une anode,
- une première jonction attenante à l'une de ces faces, cette jonction étant polarisée en sens inverse lorsqu'une tension directe est appliquée entre l'anode et la cathode,
- une seconde jonction attenante à la face opposée à la face correspondant à la première jonction, cette seconde jonction étant polarisée en sens direct lorsqu'une tension directe est appliquée entre l'anode et la cathode, et
- au moins un caisson d'isolation ayant un second type de dopage, reliant les faces avant et arrière et étant dissocié électriquement de la première jonction.

La structure est telle que lorsqu'une tension inverse est appliquée entre l'anode et la cathode, créant des lignes équipotentielles de tension, le caisson d'isolation permet de répartir les lignes équipotentielles dans le substrat.

Selon l'invention, le caisson d'isolation est dissocié électriquement de la seconde jonction. La structure périphérique est telle que lorsqu'une tension directe est appliquée entre l'anode et la cathode, créant des lignes équipotentielles de tension, le caisson d'isolation permet de répartir les lignes équipotentielles dans le substrat.

Ainsi, contrairement aux techniques de garde connues, le ou les caissons d'isolation ont dans l'invention une fonction de répartition des lignes équipotentielles dans le substrat, c'est-à-dire dans le volume de la structure, dans les deux sens de polarisation. Grâce à cette répartition, un canal d'arrêt s'avère superflu et les dimensions du composant peuvent être réduites au regard de ceux existants. De plus, des fonctions électriques peuvent être implantées sur les deux faces avant et arrière. En effet, l'anode et la cathode ne se trouvent pas en contact électrique avec les caissons d'isolation.

La structure est aussi apte à supporter des tensions symétriques. Ces tensions sont par exemple comprises entre 600 et 1200 V. Dans certains modes de réalisation, elles atteignent des valeurs comprises entre 4000 et 5000 V.

Préférentiellement, la structure périphérique comprend deux caissons d'isolation latéraux, disposés symétriquement par rapport aux jonctions. Cependant, selon une variante de réalisation, elle comprend un unique caisson d'isolation latéral d'un premier côté des jonctions, une autre technique étant employée du second côté.

La structure périphérique de l'invention est avantageusement employée dans un mode d'intégration fonctionnel, pour lequel la fonction de puissance naît d'interactions électriques entre régions semi-conductrices judicieusement agencées et dimensionnées et aussi d'interconnexions de surface. Ce mode d'intégration est particulièrement adapté à des applications hautes tensions, notamment pour des connexions à un réseau de distribution d'énergie électrique nécessitant des tenues en tensions symétriques.

Selon une autre forme d'utilisation, la structure périphérique selon l'invention est mise en oeuvre dans un mode d'intégration monolithique de puissance du type « smart-power », pour lequel des techniques d'isolation sont introduites dans le substrat afin de différencier des régions affectées à des fonctions de puissance (haute tension) et des régions supportant des circuits de commande et de traitement du signal et de l'information (basse tension).

Les jonctions définissent des caissons principaux ayant le second signe de dopage et délimités chacun par la jonction correspondante et par la face attenante.

Préférentiellement, ces caissons principaux sont périphériques.

Dans un mode de réalisation préféré, le substrat est du type N et le caisson principal et le caisson d'isolation sont du type P. La jonction est alors disposée attenante à la face avant.

Dans un autre mode de réalisation, le substrat est du type P et le caisson principal et le caisson d'isolation sont du type N, la jonction étant alors attenante à la face arrière.

Préférentiellement, le substrat est faiblement dopé et les caissons sont fortement dopés.

Le caisson d'isolation est constitué d'un mur vertical d'isolation à fort dopage et la structure comprend deux zones d'implantation à faible dose du second type de dopage, chaque zone d'implantation étant adjacente à ce mur et à l'une respective des faces avant et arrière et disposée entre le mur et l'une des première et deuxième jonctions.

Cette réalisation du caisson d'isolation et de son voisinage est particulièrement adaptée pour que le caisson d'isolation puisse remplir sa fonction de répartition des lignes équipotentielles dans le substrat. Elle permet de gagner encore en surface, le caisson d'isolation pouvant avoir une largeur réduite par rapport aux caissons utilisés dans les composants connus. A titre d'exemple, le caisson d'isolation a une largeur de l'ordre de 5 µm.

Préférentiellement, le mur d'isolation a une forme sensiblement rectangulaire.

On appelle ci-après « métallisation localisée », une métallisation d'une des faces avant ou arrière qui est localisée au niveau de la connexion associée à cette face, et qui a donc une longueur petite par rapport à la longueur de cette face. On désigne par « métallisation étendue », une métallisation non partielle d'une des faces avant ou arrière, c'est-à-dire recouvrant une portion de cette face non localisée à la connexion associée à cette face. Préférentiellement, des oxydes de champ recouvrent ies faces arrière et avant à l'exception de zones localisées au niveau des connexions. Lorsque l'une de ces faces a une métallisation localisée, cette dernière recouvre alors uniquement la zone localisée correspondante, tandis que lorsque l'une de ces faces a une métallisation étendue, cette dernière recouvre aussi au moins partiellement l'oxyde de champ correspondant.

On distingue deux modes de réalisation préférés selon qu'une métallisation étendue est effectuée seulement sur la face arrière ou sur les deux faces arrière et avant. Ces deux modes de réalisation préférés incluent le mur vertical d'isolation avec zone d'implantation voisine à faible dose.

Dans un exemple servant à la compréhension de l'invention, la structure périphérique comprend:
- au moins une première zone d'implantation à faible dose du second type de dopage adjacente à la première jonction et à la face correspondante et disposée entre la première jonction et le mur,
- au moins une seconde zone d'implantation à faible dose du second type de dopage adjacente à la seconde jonction et à la face correspondante et disposée entre la seconde jonction et le mur, et
- les zones d'implantation adjacentes au mur, respectivement adjacentes aux faces avant et arrière.

Ainsi, la structure comprend au voisinage de chacune des faces avant et arrière et en allant d'une jonction à une face latérale : le caisson principal délimité par la jonction attenante à la face avant ou arrière, la zone d'implantation à faible dose adjacente, une zone sans implantation, la zone d'implantation à faible dose adjacente au mur, et le mur d'isolation.

Cette structure est adaptée à une métallisation localisée des deux faces avant et arrière.

La structure a alors préférentiellement une configuration symétrique par rapport à un plan parallèle aux faces avant et arrière et à mi-distance de ces faces. La symétrie de la tenue en tension est ainsi améliorée.

Préférentiellement, la structure comprend deux murs d'isolation latéraux munis de zones d'implantation à faible dose en faces avant et arrière, et deux caissons principaux avant et arrière, bordés chacun latéralement par deux zones d'implantation à faible dose.

Cet exemple de structure périphérique est particulièrement intéressant pour son faible coût de fabrication et le gain de surface qu'il permet d'obtenir.

Dans un premier des deux modes de réalisation évoqués ci-dessus, la structure comprend :
- une plaque de champ arrière recouvrant-toute la face arrière, et
- deux zones d'implantation à faible dose du second type de dopage, chacune étant adjacente au mur et à une respective des faces avant et arrière et à la jonction correspondante.

Grâce à cette réalisation, on peut aussi obtenir une tenue en tension symétrique

Ainsi, la structure périphérique comprend une des zones d'implantation adjacentes au mur, adjacente à la face arrière. La présence de cette zone d'implantation arrière est d'autant plus utile pour améliorer la tenue en tension que la jonction arrière et le mur sont proches.

Ce premier mode de réalisation de la structure périphérique permet un montage facile et rapide, par brasure de la plaque de champ arrière sur une embase.

Dans le deuxième mode de réalisation mentionné plus haut, la structure périphérique comprend :
- une plaque de champ arrière recouvrant toute la face arrière,
- les zones d'implantation adjacentes au mur, respectivement adjacentes aux faces avant et arrière,
- une plaque de champ avant recouvrant partiellement la face avant entre la connexion à la cathode et la zone d'implantation adjacente au mur et à la face avant, et
- au moins une première et au moins une deuxième zones d'implantation à faible dose du second type de dopage chacune adjacente à une des jonctions et à la face correspondante.

La structure périphérique supporte au moins une tension polarisant cette jonction en sens direct.

Cette structure permet également d'obtenir une tenue en tension symétrique.

Outre les deux zones d'implantation avant et arrière adjacentes au mur, la structure périphérique comporte au moins une première d'implantation à faible dose, adjacente(s) à l'une des jonctions avant ou arrière. Dans la forme de réalisation où le substrat est du type N, il s'agit de la jonction arrière pour une utilisation en polarisation directe et de la jonction avant pour une utilisation en polarisation inverse.

Le composant comprend aussi au moins une seconde zone d'implantation à faible dose du second type de dopage, adjacente(s) à l'autre jonction et à la face correspondante. Ainsi, il permet d'assurer une tenue en tension symétrique.

Dans un exemple différent du deuxième mode de réalisation où seule l'une des jonctions avant ou arrière est prolongée par une (ou deux) zone d'implantation à faible dose, le composant est particulièrement adapté au fonctionnement dans un sens de tension. Cependant, il reste capable de fonctionner également en sens opposé avec un champ électrique maximum sensiblement moins élevé, le caisson d'isolation remplissant son rôle de répartition des lignes équipotentielles dans le substrat.

Le deuxième mode de réalisation de la structure qui permet, comme le premier mode de réalisation le montage de la face arrière par brasure, rend possible une diminution de surface grâce à la présence de la plaque de champ avant.

Dans une forme de réalisation préférée des zones d'implantation à faible dose adjacentes aux jonctions, celles-ci sont du type à terminaison de jonction.

Dans des variantes de réalisation, elles sont choisies parmi les anneaux de garde, les électrodes de champ ou plaques de champ, les couches semi-résistives ou les terminaisons de jonctions graduelles.

La structure est préférentiellement du type planar.

Avantageusement, le premier type de dopage est N et le second type de dopage est P.

La structure est préférentiellement symétrique par rapport à un plan perpendiculaire aux faces avant et arrière et au plan du substrat.

Il est avantageux que la structure comprenne des oxydes de champ recouvrant les faces avant et arrière en des zones excluant les première et deuxième jonctions et incluant le ou les caissons d'isolation. Ces oxydes de champ sont interposés entre les faces avant et arrière d'une part, et les plaques de champ d'autre part.

La présente invention sera mieux comprise à la lecture de la description qui suit d'exemples de réalisation de structures périphériques pur dispositifs monolithiques de puissance selon l'invention, donnée à titre indicatif et nullement limitatif, en référence aux dessins annexés sur lesquels:
- la figure 1 représente une demi-coupe schématique d'un exemple d'une structure périphérique pour dispositif monolithique de puissance, sans plaque de champ ;
- la figure 2 montre un exemple de répartition des lignes équipotentielles de tension avec l'exemple de la figure 1, dans un premier mode opératoire;
- la figure 3 montre un exemple de répartition des lignes de courant au moment du claquage par avalanche avec l'exemple de la figure 1, dans le premier mode opératoire;
- la figure 4 montre un exemple de répartition des lignes de courant au moment du claquage par avalanche avec l'exemple de la figure 1, dans un second mode opératoire ;
- la figure 5 représente une demi-coupe schématique d'un premier mode de réalisation d'une structure périphérique pour dispositif monolithique de puissance selon l'invention, comprenant une plaque de champ arrière ;
- la figure 6 montre un exemple de répartition des lignes équipotentielles de tension obtenu avec le mode de réalisation de la figure 5, dans un premier mode opératoire associé à une différence de tension négative entre l'anode et la cathode ;
- la figure 7 montre un exemple de répartition des lignes équipotentielles de tension obtenu avec le mode de réalisation de la figure 5, dans un second mode opératoire associé à une différence de tension négative entre l'anode et la cathode ;
- la figure 8 montre un exemple de répartition des lignes équipotentielles de tension obtenu avec le mode de réalisation de la figure 5, dans un mode opératoire associé à une différence de tension positive entre l'anode et la cathode ;
- la figure 9 visualise un agrandissement d'une zone représentée sur la figure 8 ;
- la figure 10 représente une demi-coupe schématique d'un deuxième mode de réalisation d'une structure périphérique pour dispositif monolithique de puissance selon l'invention, comprenant des plaques de champ avant et arrière ;
- la figure 11 montre un exemple de répartition des lignes équipotentielles de tension obtenu avec le mode de réalisation de la figure 10, pour un premier mode opératoire associé à une différence de tension négative entre l'anode et la cathode ;
- la figure 12 montre un exemple de répartition des lignes équipotentielles de tension obtenu avec le mode de réalisation de la figure 10, pour un second mode opératoire associé à une différence de tension négative entre l'anode et la cathode ;
- la figure 13 montre un exemple de répartition des lignes équipotentielles de tension obtenu avec le mode de réalisation de la figure 10, dans un premier mode opératoire associé à une différence de tension positive entre l'anode et la cathode ;
- la figure 14 montre un exemple de répartition des lignes équipotentielles de tension obtenu avec le mode de réalisation de la figure 10, pour un second mode opératoire associé à une différence de tension positive entre l'anode et la cathode.

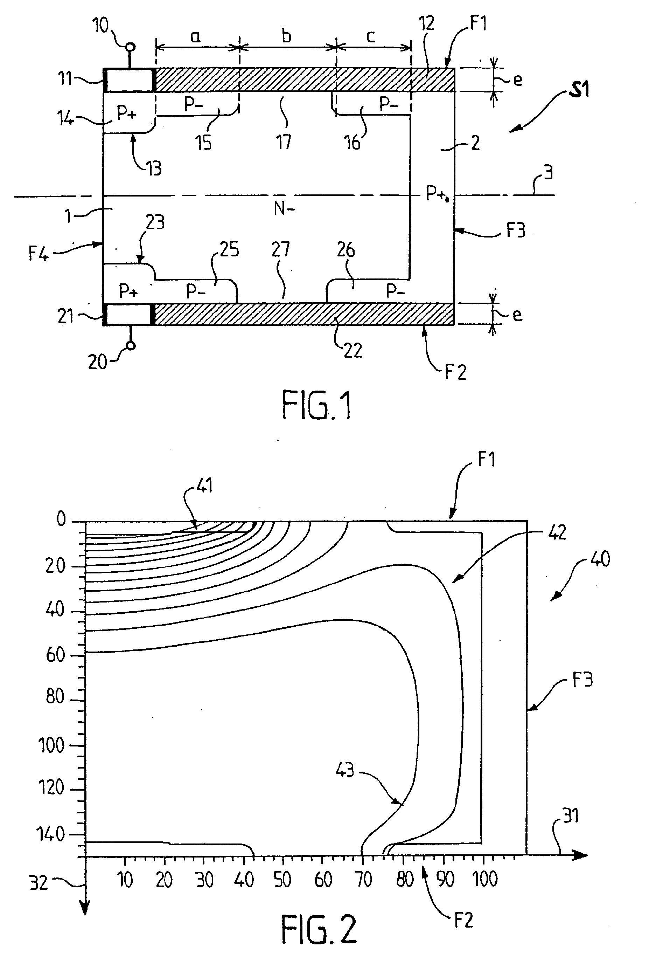

Tous les exemples de répartition des lignes équipotentielles de tension représentés aux figures 2 à 4, 6 à 9 et 11 à 14 sont les résultats de simulations numériques. Sur ces figures, les limites de la zone de charge d'espace, dans laquelle sont concentrées les lignes équipotentielles de tension, sont référencées 200.

Sur les figures 1, 5 et 10, des éléments similaires sont identifiés par les mêmes références. Pour simplifier la représentation des structures sur ces figures, seule une moitié de structure est schématisée, l'autre moitié étant obtenue par symétrie. Bien entendu, les connexions à l'anode et à la cathode sont à exclure de cette symétrie.

Un exemple d'une structure périphérique pour dispositif monolithique de puissance, référencée S1 (figure 1), est du type planar et sensiblement rectangulaire. La demi-structure représentée comporte trois faces F1-F3 et une quatrième face F4 fictive définissant un plan de symétrie 4.

Les faces F1 et F2, opposées, comprennent respectivement des parties métalliques 11 et 21 reliées à des connexions 10 et 20 à une cathode et à une anode. La cathode est avantageusement mise à la masse. Les parties métalliques 11 et 21 sont préférentiellement disposées à des extrémités opposées des faces F1 et F2. Des oxydes de champ 12 et 22 recouvrent respectivement le reste des faces F1 et F2.

La structure S1 comprend un substrat 1 constitué d'une région de substrat profonde et faiblement dopée N-, obtenue par diffusion. Un mur vertical d'isolation 2 fortement dopé P+ relie les oxydes de champ 12 et 22 des faces F1 et F2 en des extrémités des faces F1 et F2 opposées aux parties métalliques 11 et 21. Ce mur 2, constituant avantageusement une région rectangulaire uniformément dopée, est par exemple réalisé par une diffusion de bore à partir de silicium polycristallin déposé dans une tranchée ou à l'aide de la technique de thermomigration de l'aluminium. Il est délimité latéralement par la face F3.

Dans une variante de réalisation, le mur 2 a une forme non rectangulaire élargie au niveau des faces F1 et F2, et est élaboré par diffusion classique de bore. Une surface de silicium beaucoup plus importante que dans les modes de réalisation précédents est alors nécessaire.

La structure S1 comporte deux caissons périphériques principaux 14 et 24 fortement dopés P+ et respectivement adjacents aux parties métalliques 11 et 21 associées à la cathode et à l'anode. Ils définissent respectivement des jonctions 13 et 23. Des diffusions peuvent être introduites dans ces caissons 14 et 24 afin d'obtenir des fonctions électriques de puissance particulières.

Dans ce qui suit, on note VBD⁺ la tenue en tension maximale en polarisation inverse de la jonction 13 de la face avant F1 et VBD⁻ la tenue en tension minimale en polarisation inverse de la jonction 23 de la face arrière F2.

Les jonctions 13 et 23 sont respectivement protégées par des implantations 15 et 25 faiblement dopées P-, attenantes aux faces F1 et F2. Ces implantations 15 et 25 sont préférentiellement des terminaisons de jonctions (JTE - Junction Termination Extension), constituant une technique de garde de jonction. Dans des variantes de réalisation, les implantations 15 et 25 sont choisies parmi d'autres techniques de garde telles que des terminaisons de jonctions graduelles, des anneaux, des électrodes de champ et des couches semi-résistives.

Deux autres implantations 16 et 26 faiblement dopées P- et respectivement adjacentes aux oxydes de champ 12 et 22 des faces F1 et F2 sont juxtaposées au mur d'isolation 2.

La structure périphérique planar S1 est préférentiellement symétrique par rapport à un plan 3 parallèle aux faces F1 et F2 et à mi-distance de ces faces. Ainsi, le comportement électrique et la tenue en tension de la structure S1 sont symétriques au regard d'une inversion de polarisation de la différence de tension entre l'anode et la cathode, ci-après notée VAK.

Le long de chacune des faces F1 et F2, on a donc successivement un des caissons principaux 14 et 24, une des implantations 15 et 25 de longueur a, une zone du substrat 1 de longueur b, respectivement notée 17 et 27, une des implantations 16 et 26 de longueur c et le mur 2. Pour une filière technologique donnée, on optimise la structure S1 au moyen des paramètres constitués par les longueurs a, b et c.

A titre d'exemple, le mur 2 a une largeur de l'ordre de 20 µm et la somme des longueurs a, b et c est comprise entre 80 µm et 100 µm.

Pour expliquer le fonctionnement de la structure S1, il suffit de le décrire pour la tension VAK positive, du fait que la structure S1 a un fonctionnement symétrique lorsque la tension VAK est négative.

La tension VAK étant positive, la jonction 13 est en polarisation inverse et la jonction 23 est en polarisation directe. Des lignes équipotentielles de tension sont alors présentes dans l'ensemble de la structure S1. L'implantation 15 protège la jonction 13 en étalant les lignes de potentiel.

Dans un premier mode opératoire, une augmentation de la tension VAK provoque un perçage du champ électrique au niveau de l'implantation 16 et les lignes de potentiel sont dirigées vers la face inférieure F2 par l'intermédiaire du mur 2. Cependant, le champ électrique ne perce pas dans la région de l'implantation 25 attenante à la jonction arrière 23. Ce premier mode opératoire est obtenu lorsque la distance b est suffisamment grande. Ainsi, dans un exemple de réalisation particulier, on a : a = 20 µm, b = 40 µm, c = 20 µm, e = 1 µm, VAK = 510 V, VBD⁺ = 620 V.

On représente alors, selon des axes 31 et 32 respectivement parallèles aux faces F1 et F3 (gradués en microns), les lignes équipotentielles ayant une répartition 40 dans le volume de la structure (figure 2). Dans une zone 41 centrée sur la jonction 13, les lignes équipotentielles sont réparties grâce à l'implantation 15. Dans une zone 42 voisine de l'implantation avant 16 adjacente au mur 2, les lignes équipotentielles sont dirigées vers la face arrière F2 et dans une zone 43 voisine de l'implantation arrière 26 adjacente au mur 2, les lignes de potentiel sont réparties par l'implantation 26, qui joue le même rôle que l'implantation 15 en évitant le resserrement naturel des lignes équipotentielles.

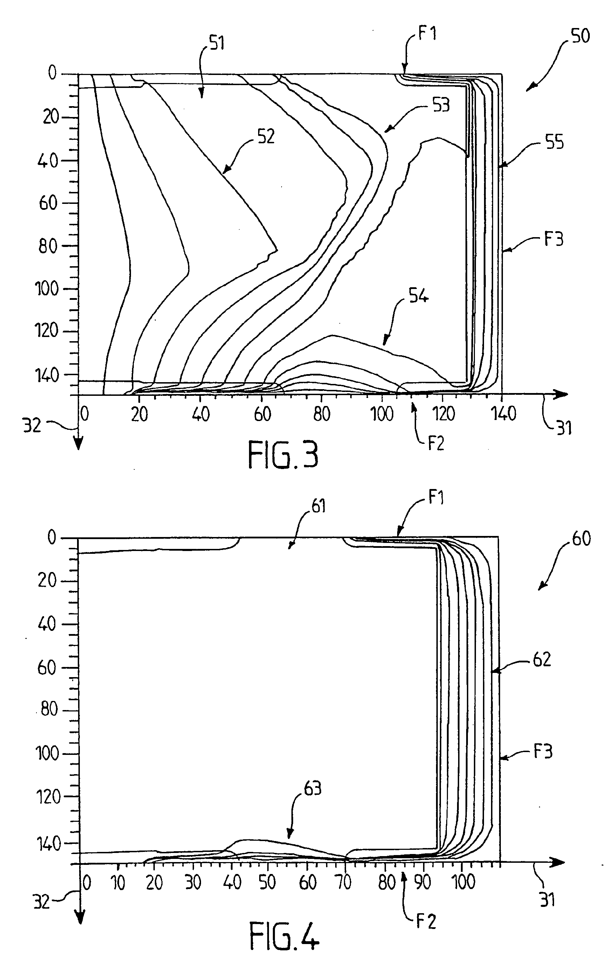

Dans ce premier mode opératoire, le champ électrique maximal entraînant un claquage par avalanche est nécessairement localisé entre la jonction avant 13 et l'implantation 15 adjacente. Ainsi, dans un exemple de réalisation pour lequel :
a = 45 µm, b = 45 µm, c = 20 µm, e = 1 µm, VAK = 830 V, VBD⁺ = 850 V,
on visualise une répartition 50 des lignes de courant au moment du claquage par avalanche (figure 3). La répartition 50 comporte une zone de claquage 51 partant de l'implantation avant 15 et descendant jusqu'au niveau de la face arrière F2, cette zone de claquage 51 étant entourée de deux groupes de lignes de courant 52 et 53 descendant de la face avant F1 vers la face arrière F2. Un ensemble de lignes de courant sont également formées dans une zone 54 entourant l'implantation arrière 26 adjacente au mur 2.

Dans un second mode opératoire, une augmentation de la tension VAK provoque l'apparition d'un second perçage du champ électrique dans la région de l'implantation 25 adjacente à la jonction arrière 23, en plus du perçage dans la région de l'implantation avant 16 adjacente au mur 2. Les deux jonctions 13 et 23 sont alors directement reliées électriquement par l'intermédiaire du mur d'isolation 2. Le claquage est obtenu pour une tension d'avalanche plus faible que dans le premier mode opératoire. Dans un exemple de réalisation pour lequel :
a = 20 µm, b = 35 µm, c = 20 µm, e = 1 µm, VAK = 450 V, VBD⁺ = 460 V,
on obtient une répartition 60 des lignes de courant au moment du claquage par avalanche (figure 4). Les lignes de courant comprennent alors trois parties 61, 62 et 63 s'étendant respectivement dans la zone 17 avant, le mur 2 et la zone 27 arrière.

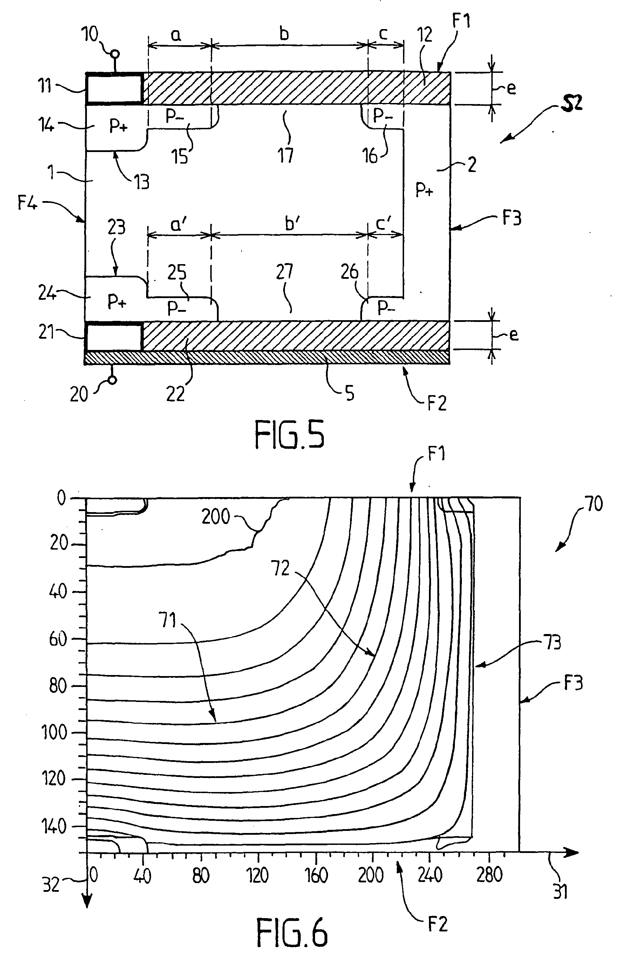

Dans un premier mode de réalisation d'une structure périphérique pour dispositif monolithique de puissance, référencée S2 et représentée sur la figure 5, la face arrière F2 est recouverte par une plaque de champ 5. Cette plaque de champ, sous forme d'une métallisation, résulte d'un montage de la face arrière F2 par brasure. Ainsi, contrairement à la structure S1, la structure S2 n'a pas une géométrie symétrique. Cette structure S2 permet toutefois d'obtenir une tenue en tension symétrique au regard d'une inversion de polarisation de la tension VAK.

De plus, les longueurs respectives de l'implantation 25, de la zone 27 et de l'implantation 26 longeant la face arrière F2 sont respectivement désignées par a', b' et c', qui peuvent différer des longueurs a, b et c correspondantes au niveau de la face avant F1.

Dans les exemples qui suivent, les longueurs a', b' et c' sont respectivement égales aux longueurs a, b et c.

Lorsque la tension VAK est négative, la jonction arrière 23 est polarisée en inverse et la jonction avant 13 en sens direct. L'implantation 25 adjacente à la jonction arrière 23 protège cette dernière. La plaque de champ 5 arrière impose au champ électrique de percer dans la région de l'implantation arrière 26 adjacente au mur 2, pour des tensions plus faibles qu'en l'absence de cette plaque 5. Les lignes équipotentielles sont ensuite dirigées vers la face avant F1 de la structure de la structure S2 à travers le mur 2.

Comme dans l'exemple de structure S1, on distingue un premier mode opératoire dans lequel le champ électrique ne perce pas dans la région de l'implantation 15 adjacente à la jonction avant 13, et un second mode opératoire dans lequel ce second perçage a lieu en plus de celui dans la zone de l'implantation arrière 26.

Ainsi, dans une configuration particulière, correspondant au premier mode opératoire (pour la tension VAK négative) et tel que : a = 20 µm, b = 210 µm, c = 20 µm, e = 1 µm, VAK = -1115 V, VBD⁺ = 620 V, VBD⁻ = -1115 V, on obtient une répartition 70 des lignes équipotentielles (figure 6). Les lignes de potentiel comprennent une première partie 71 dans laquelle elles s'étendent au-dessus de la face arrière F2, une deuxième partie 72 de remontée vers la face avant F1 et une troisième partie 73 où elles remontent parallèlement au mur 2 jusqu'à la face avant F1.
Dans ce premier mode opératoire (avec la tension VAK négative), le champ électrique maximal responsable du claquage par avalanche est localisé à la fin de la région de l'implantation avant 16 adjacente au mur 2.

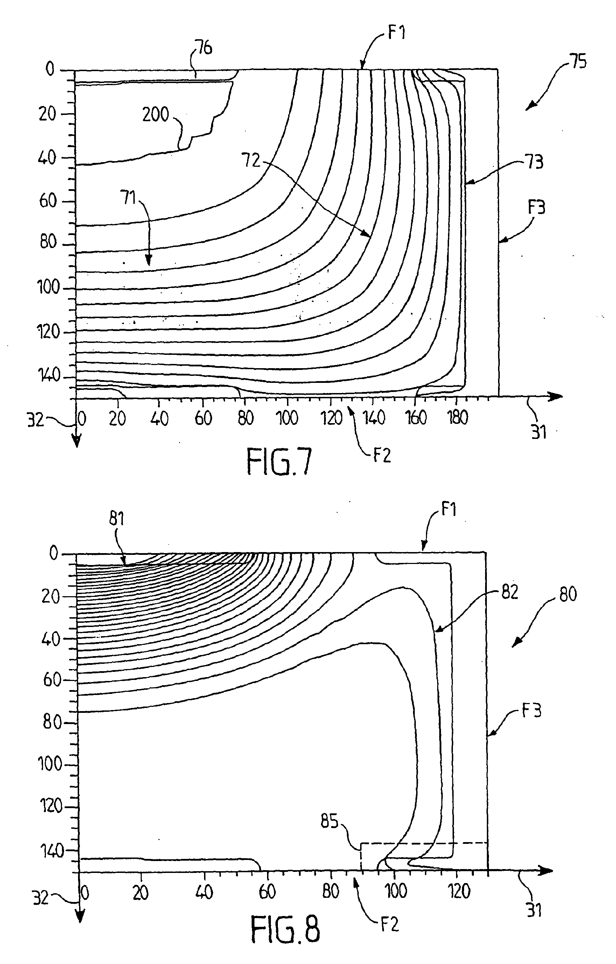

Dans le second mode opératoire (avec la tension VAK négative), un second perçage du champ électrique existe dans la région de l'implantation 15 adjacente à la jonction avant 13, les jonctions 13 et 23 étant directement reliées électriquement. Ainsi, dans une configuration particulière dans laquelle:
a = 55 µm, b = 90 µm, c = 20 µm, e = 1 µm, VAK = -800 V, VBD⁺ = 945 V, VBD⁻ = -800 V,
on trouve une répartition 75 des lignes équipotentielles (figure 7). On observe, outre des parties 71, 72 et 73 similaires à celles du premier mode opératoire (figure 6), une quatrième zone 76 de percée dans la région de l'implantation 15.

Le fonctionnement selon le premier ou le second mode opératoire dépend de la longueur b, le second mode opératoire se produisant lorsque b est trop faible. En cas de dissymétrie des longueurs a, b et c au niveau des faces avant F1 et arrière F2, c'est la longueur b de la face avant F1 qui est déterminante. De plus, la valeur critique de la longueur b à partir de laquelle se déclenche le second perçage du champ électrique, est supérieure de l'ordre de 25 % à la valeur critique obtenue en l'absence de la plaque de champ 5. Cette augmentation s'explique par le fait que la plaque de champ 5 impose à toutes les lignes équipotentielles de remonter vers la face avant F1, au lieu qu'il se produise une répartition des lignes équipotentielles entre les faces avant F1 et arrière F2, comme dans la structure S1.

Lorsque la tension VAK est positive, la jonction avant 13 est polarisée en inverse et la jonction arrière 23 en direct. La jonction avant 13 est alors protégée par l'implantation 15. On distingue deux modes opératoires selon la valeur de la longueur b.

Dans le premier mode opératoire (avec la tension VAK positive), le champ électrique ne perce pas dans la région de l'implantation 25 attenante à la jonction arrière 23. Ce premier mode opératoire peut lui-même se présenter selon deux situations suivant la longueur b. Si la longueur b est suffisante, les lignes équipotentielles se répartissent comme avec une terminaison de jonction classique, le champ électrique maximal étant réparti entre la jonction avant 13 et l'implantation 15 attenante.

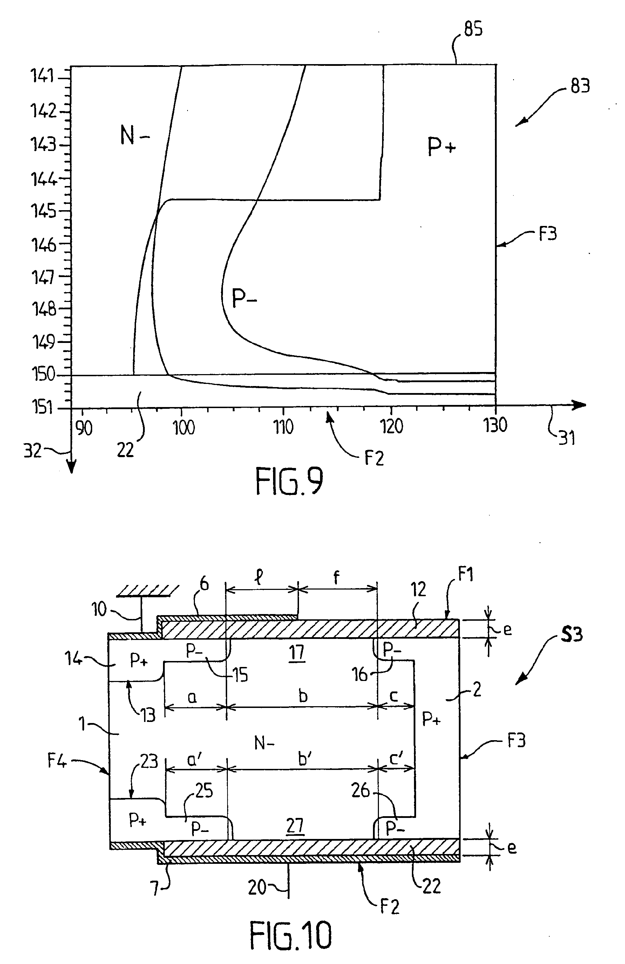

Dans une autre configuration du premier mode opératoire, la longueur b est en dessous d'une valeur critique à partir de laquelle les lignes de potentiel atteignent la région de l'implantation avant 16 attenante au mur 2. Elles sont ensuite dirigées vers la face arrière F2 de la structure S2 à travers le mur 2. Un exemple de cette configuration pour lequel :
a = 35 µm, b = 45 µm, c = 20 µm, e = 1 µm, VAK = 820 V, VBD⁺ = 820 V, VBD⁻ = -300 V
conduit ainsi à une répartition 80 (figures 8 et 9). Une partie des lignes équipotentielles se concentre ainsi autour d'une zone 81 centrée sur l'implantation 15 attenante à la jonction avant 13. Certaines des lignes équipotentielles sont déviées au niveau d'une zone 82 située sous l'implantation 16 attenante au mur 2 vers la face arrière F2. Ces lignes équipotentielles sont ainsi déviées vers une fenêtre 85 formant un coin délimité par les faces arrière F2 et latérale F3 et elles aboutissent dans une zone 83 au niveau de l'oxyde de champ arrière 22. La métallisation de la face arrière F2 impose aux lignes équipotentielles de pénétrer dans l'oxyde 22 sous la région de l'implantation 26 pour ressortir sur la face latérale F3 de la structure. Dans cette configuration du premier mode opératoire, le champ électrique maximal est localisé dans le silicium au niveau de l'interface entre l'implantation arrière 26 et l'oxyde de champ 22.

Dans le second mode opératoire (pour la tension VAK positive), obtenu lorsque la longueur b est trop faible, le champ électrique perce dans la région de l'implantation 25 adjacente à la jonction arrière 23.

Qu'il s'agisse du premier mode opératoire dans cette seconde configuration ou du second mode opératoire, il convient d'optimiser la structure S2 de manière à éviter d'atteindre le champ électrique critique de l'oxyde de champ 22 sous la plaque de champ 5.

Dans une variante de ce premier mode de réalisation avec plaque de champ arrière 5, les longueurs a, b et c diffèrent entre la face avant F1 et la face arrière F2. Dans ce cas, la longueur b de la face arrière F2 est déterminante pour l'appartenance au premier mode opératoire ou au second mode opératoire et la distance b de la face avant F1 est déterminante dans le premier mode opératoire pour l'appartenance à la première configuration ou à la seconde configuration.

Dans un deuxième mode de réalisation, avec plaques de champ avant et arrière, la structure étant référencée S3 et représentée sur la figure 10, une plaque de champ avant 6 recouvre partiellement la face avant F1, une plaque de champ arrière 7 recouvre complètement la face arrière F2. Les plaques de champ sont obtenues sous forme de métallisation.

La structure S3 est obtenue, à partir d'un montage de la face arrière F2 par brasure, en ajoutant la plaque de champ 6 sur la face avant.

La plaque de champ avant 6 couvre la partie de la face avant F1 surmontant l'implantation 15 adjacente à la jonction avant 13 et déborde de cette partie d'une distance ℓ, pour s'interrompre au niveau de la zone 17 du substrat 1. La plaque de champ avant 6 a ainsi une extrémité distante d'une longueur f de la partie de la face avant F1 surmontant l'implantation avant 16, la longueur b étant la somme des longueurs ℓ et f.

De plus, les longueurs respectives de l'implantation 25, de la zone 27 et de l'implantation 26 longeant la face arrière F2 sont respectivement désignées par a', b' et c', qui peuvent différer des longueurs a, b et c correspondantes au niveau de la face avant F1.

La structure périphérique S3 n'a donc pas de topologie symétrique. La structure S3 permet cependant d'obtenir une tenue en tension symétrique.

Pour la tension VAK négative, la jonction 23 est polarisée en inverse. La plaque de champ arrière 7 impose alors aux lignes équipotentielles d'atteindre la région de l'implantation arrière 26 à des tensions VAK plus faibles qu'en l'absence de la plaque de champ arrière 7. Toutes les lignes équipotentielles sont ensuite dirigées sur la face avant F1 à travers le mur 2. Elles s'étalent alors sur la face avant F1 depuis le mur 2 jusqu'au droit de la plaque de champ avant 6.

On distingue deux modes opératoires (avec la tension VAK négative) selon la longueur ℓ. Dans un premier mode opératoire, il n'y a pas de second perçage du champ électrique dans la région de l'implantation 15 adjacente à la jonction avant 13, en plus du perçage au niveau de l'implantation arrière 26. Dans une configuration correspondant à ce premier mode opératoire, on a :
a = 10 µm, b = 50 µm, c = 20 µm, a' = 20 µm, b' = 40 µm, c' = 20 µm,
ℓ = 30 µm, f = 20 µm, e = 1 µm, VAK = -405 V, VBD⁺ = 250 V, VBD⁻ = -470 V.

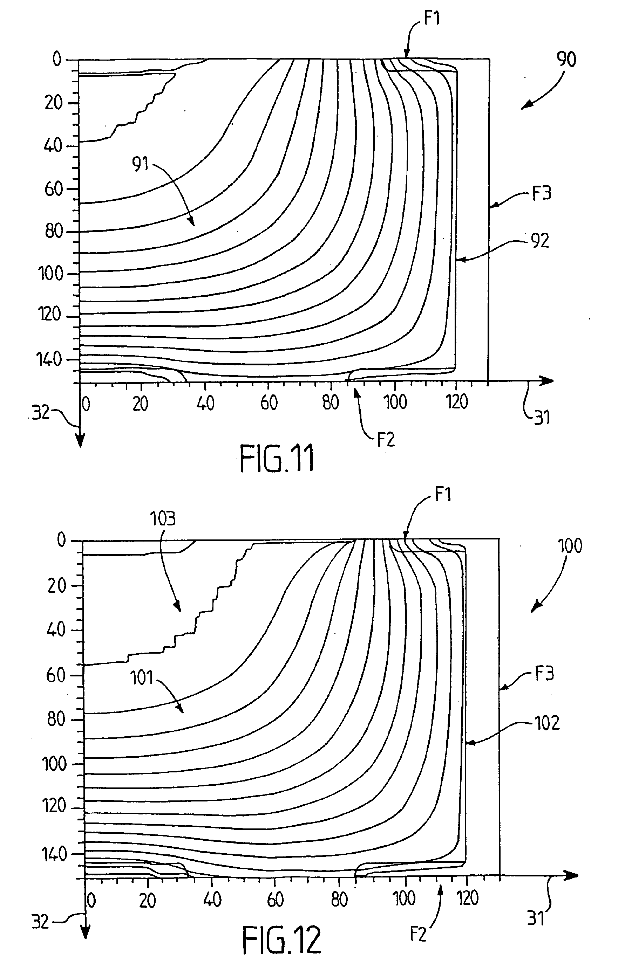

Les lignes équipotentielles ont alors une répartition 90 (figure 11), comportant une partie 91 longeant la face arrière F2, et une partie 92 verticale, longeant le mur 2 et reliant la face arrière F2 à la face avant F1. Le champ électrique maximal responsable du claquage par avalanche se situe à la fin de la plaque de champ 6 de la face avant F1, au niveau de la zone 17.

Dans le second mode opératoire (pour la tension VAK négative), la longueur ℓ est trop faible et un second perçage du champ électrique se produit dans la région de l'implantation 15 attenante à la jonction avant 13. Ainsi, dans une configuration pour laquelle:
a = 10 µm, b = 70 µm, c = 20 µm, a' = 10 µm, b' = 60 µm, c' = 30 µm,
ℓ = 35 µm, f = 35 µm, e = 1 µm, VAK = -675 V, VBD⁺ = 350 V, VBD⁻ = -680 V, la répartition 100 des lignes équipotentielles (figure 12) comprend une partie 101 de lignes longeant la face arrière F2 et se prolongeant en une partie 102 approximativement verticale longeant le mur 2, ainsi qu'une partie 103 de lignes équipotentielles centrée sur l'implantation 15 attenante à la jonction avant 13.

La plaque de champ avant 6 permet de réduire de façon significative la longueur b par rapport à la structure correspondante n'ayant que la plaque de champ arrière 7, afin d'obtenir une même tenue en tension (dans le cas d'une polarisation négative de la tension VAK). La réduction atteint par exemple 33 %.

Lorsque la tension VAK est positive, la jonction avant 13 est polarisée en inverse. La plaque de champ avant 6 protège alors la jonction 13 en étalant les lignes équipotentielles sur toute sa longueur. Le resserrement des lignes équipotentielles s'effectue en fin de métallisation, au niveau de la zone 17. On distingue deux modes opératoires selon la valeur de la longueur f.

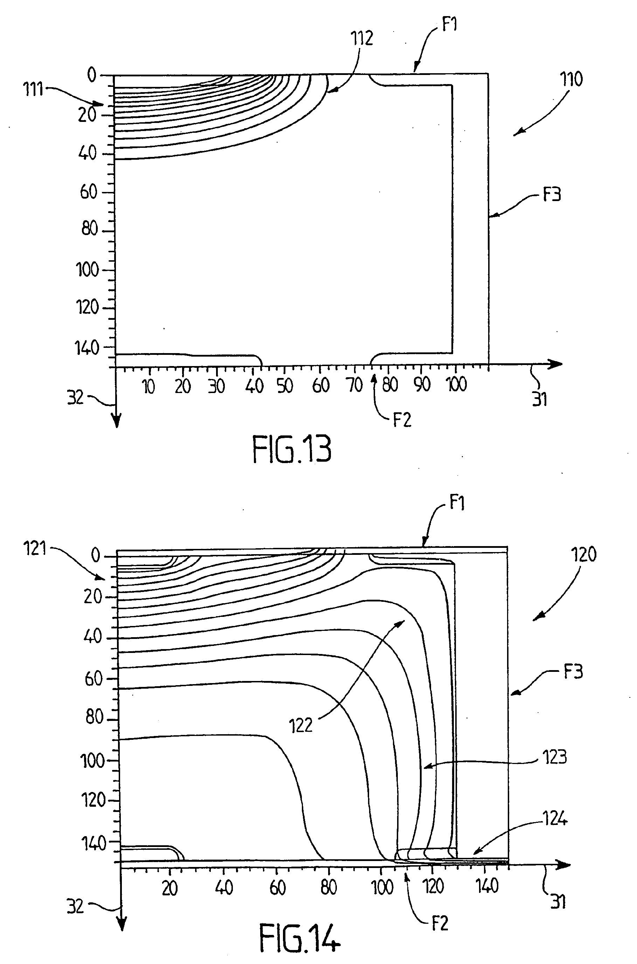

Dans un premier mode opératoire, la distance f est suffisante pour qu'il n'y ait pas de perçage du champ électrique dans la région de l'implantation avant 16 attenante au mur 2. Toutes les lignes équipotentielles restent alors sur la face avant F1 de la structure. La localisation du champ électrique maximal responsable du claquage par avalanche dépend de l'épaisseur e de l'oxyde de champ avant 12 : il est localisé soit en fin de métallisation au niveau de la zone 17, soit au niveau de la jonction avant 13. Dans une configuration dans laquelle:
a = 10 µm, b = 50 µm, c = 20 µm, a' = 20 µm, b' = 40 µm, c' = 20 µm, ℓ = 15 µm, f = 35 µm, e = 1 µm, VAK = 265 V, VBD⁺ = 265 V, VBD⁻ = -470 V,
on obtient ainsi une répartition 110 des lignes équipotentielles (figure 13), dans laquelle les lignes équipotentielles sont centrées sur une région 111 au voisinage de l'implantation 15 adjacente à la jonction avant 13. Ces lignes sont délimitées par des lignes limites 112 aboutissant dans la zone 17.

Dans le second mode opératoire (pour la tension VAK positive), la distance f est inférieure à une valeur critique de telle sorte qu'il y perçage du champ électrique dans la région de l'implantation avant 16 attenante au mur 2. Plusieurs lignes équipotentielles sont alors dirigées vers la face arrière F2 de la structure S3 à travers le mur 2. La présence de la plaque de champ arrière 7 impose à ces lignes de potentiel de pénétrer dans l'oxyde de champ 22 pour ressortir au niveau de la face latérale F3 sur la tranche de la plaquette. La tenue en tension est déterminée par un claquage par avalanche dans le silicium, soit en fin de plaque de champ avant 6, au niveau de la zone 17, soit à l'interface entre l'implantation arrière 26 et le mur 2. La tenue en tension est plus importante qu'en l'absence de la plaque de champ arrière 7 avec présence de la plaque de champ avant 6. En effet, à partir d'une certaine tension de polarisation, les lignes équipotentielles sont dirigées vers la face arrière F2, limitant leur resserrement sur la face avant F1. Cette situation peut être constatée sur une configuration dans laquelle:
a = 0 µm, b = 81 µm, c = 29 µm, a' = 0 µm, b' = 90 µm, c' = 20 µm, ℓ = 56 µm,
f = 25 µm, e = 3 µm, VAK = 635 V, VBD⁺ = 900 V, VBD⁻ = -910 V,
conduisant à une répartition 120 des lignes équipotentielles (figure 14). Une partie des lignes équipotentielles est resserrée dans une zone 121 centrée sur l'implantation 15 attenante à la jonction avant 13. Plusieurs lignes équipotentielles percent dans une zone 122 centrée sur l'implantation avant 16 adjacente au mur 2 et un grand nombre de lignes équipotentielles sont dirigées vers une zone 123 centrée autour de l'implantation arrière 26 attenante au mur 2 pour pénétrer dans une zone 124 de l'oxyde de champ arrière 22.

Dans les deux cas, avec tensions VAK positive et négative, les paramètres suivants sont les plus influents pour la tenue en tension : la position de la plaque de champ avant 6, la longueur b et l'épaisseur e de l'oxyde de champ 12 sur la face avant F1.

## Revendications

1. Structure périphérique (S2, S3) pour dispositif monolithique de puissance comprenant :
- un substrat (1) ayant un premier type de dopage (N),
- une face avant (F1) munie d'une connexion (10) à une cathode,
- une face arrière (F2) munie d'une connexion (20) à une anode,
- une première jonction (13) attenante à l'une desdites faces (F1), ladite première jonction (13) étant polarisée en sens inverse lorsqu'une tension directe est appliquée entre l'anode et la cathode,
- une seconde jonction (23) attenante à la face (F2) opposée à la face (F1) correspondant à la première jonction (13), ladite seconde jonction (23) étant polarisée en sens direct lorsqu'une tension directe est appliquée entre l'anode et la cathode, et
- au moins un caisson d'isolation (2) ayant un second type de dopage (P), reliant les faces avant (F1) et arrière (F2) en une extrémité de ces faces,
et étant dissocié électriquement de la première jonction,
- ledit caisson d'isolation (2) étant dissocié électriquement de la seconde jonction (23),
- ledit caisson d'isolation (2) étant constitué d'un mur vertical d'isolation (2) à fort dopage,
- la structure (S2, S3) comprenant deux zones d'implantation (16, 26) à faible dose du second type de dopage (P), chaque zone d'implantation (16, 26) étant adjacente audit mur (2) et à l'une respective des faces avant (F1) et arrière (F2) et disposée entre ledit mur (2) et l'une desdites première et deuxième jonctions (13, 23),
- les première et deuxième jonctions (13, 23), le caisson d'isolation (2), ainsi que les zones d'implantation (16, 26) étant dans une configuration symétrique par rapport à un plan (3) parallèle aux faces avant (F1) et arrière (F2), et à mi-distance desdites faces,
- la structure (S2, S3) comprenant une plaque de champ arrière (5, 7) recouvrant toute la face arrière (F2).

2. Structure périphérique (S2, S3) selon la revendication 1, **caractérisée en ce qu'**elle comprend :
- au moins une première zone d'implantation (15) à faible dose du second type de dopage (P) adjacente à la première jonction (13) et à la face (F1) correspondante et disposée entre la première jonction (13) et ledit mur (2),
- au moins une seconde zone d'implantation (25) à faible dose du second type de dopage (P) adjacente à la seconde jonction (23) et à la face (F2) correspondante et disposée entre la seconde jonction (23) et ledit mur (2).

3. Structure périphérique (S3) selon la revendication 2, **caractérisée en ce qu'**elle comprend :
- une plaque de champ avant (6) recouvrant partiellement la face avant (F1) entre la connexion (10) à la cathode et ladite zone d'implantation (16) adjacente au mur (2) et à la face avant (F1).

4. Structure périphérique (S2, S3) selon l'une quelconque des revendications 2 ou 3, **caractérisée en ce que** lesdites zones d'implantation (15, 25) à faible dose adjacentes aux première et deuxième jonctions (13, 23) sont du type à terminaison de jonction.

5. Structure périphérique (S2, S3) selon l'une quelconque des revendications 1 à 4, **caractérisée en ce que** ladite structure (S2, S3) est du type planar.

6. Structure périphérique (S2, S3) selon l'une quelconque des revendications 1 à 5, **caractérisée en ce que** le premier type de dopage est N et le second type de dopage est P.

7. Structure périphérique (S2, S3) selon l'une quelconque des revendications 1 à 6, **caractérisée en ce que** ladite structure (S2, S3) est symétrique par rapport à un plan (F4) perpendiculaire aux faces avant (F1) et arrière (F2) et au plan du substrat (1).

8. Structure périphérique (S2, S3) selon l'une quelconque des revendications 1 à 7, **caractérisée en ce qu'**elle comprend des oxydes de champ (12, 22) recouvrant respectivement les faces avant (F1) et arrière (F2) en des zones excluant les première et deuxième jonctions (13, 23) et incluant ledit caisson d'isolation (2), lesdits oxydes de champ (12, 22) étant interposés entre la face arrière (F2) et la plaque de champ arrière (5,7) et entre la face avant (F1) et une plaque de champ avant (6) selon la revendication 3 si celle-ci est prévue, respectivement.

## Claims

1. A peripheral structure (S2, S3) for monolithic power device comprising:
- a substrate (1) with a first doping type (N),
- a front face (F1) fitted with a connection (10) to a cathode,
- a rear face (F2) fitted with a connection (20) to an anode,
- a first junction (13) adjoining one of the faces (F1), said first junction (13) being reverse-biased when a forward voltage is applied between the anode and the cathode,
- a second junction (23) adjoining the face (F2) opposed to the face (F1) corresponding to the first junction (13), said the second junction (23) being forward-biased when a forward voltage is applied between the anode and the cathode, and
- at least one insulating box (2) with a second type of doping (P), connecting the front (F1) and rear (F2) faces at one end of these faces, and disconnected electrically from the first junction,
- said insulating box (2) being disconnected electrically from the second junction (23),
- said insulating box (2) being made of a highly doped insulating vertical wall (2),
- the structure (S2, S3) comprising two small dose implantation zones (16, 26) of the second doping type (P), each implantation zones (16, 26) being adjacent to said wall (2) and to one respective of the front (F1) and rear (F2) faces and arranged between said wall (2) and one of the said first and second junctions (13, 23),
- the first and second junctions (13, 23), the insulating box (2) and the implantation zones (16, 26) being symmetrically arranged with respect to a plane (3) parallel to the front (F1) and rear (F2) faces and halfway between said faces,
- the structure (S2, S3) comprising a rear field plate (5, 7) covering the whole rear face (F2).

2. A peripheral structure (S2, S3) according to claim 1, **characterised in that** it comprise:
- at least a first small dose implantation zone (15) of the second type of doping (P) adjacent to the first junction (13) and to the corresponding face (F1) and arranged between the first function (13) and said wall (2),
- at least a second small dose implantation zone (25) of the second type of doping (P) adjacent to the second junction (23) and to the corresponding face (F2) and arranged between the second junction (23) and the said wall (2).

3. A peripheral structure (S3) according to claim 2, **characterized in that** it comprises:
- a front field plate (6) covering partially the front face (F1) between the connection (10) to the cathode and said implantation zone (16) adjacent to the wall (2) and the front face (F1).

4. A peripheral structure (S2, S3) according to claim 2 or 3, **characterized in that** said small dose implantation zones (15, 25) adjacent to the first and second junctions (13, 23) are of the junction termination type.

5. A peripheral structure (S2, S3) according to any of claims 1 to 4, **characterized in that** said structure (S2, S3) is of the planar type.

6. A peripheral structure (S2, S3) according to any of claims 1 to 5, **characterized in that** the first doping type is N and the second doping type is P.

7. A peripheral structure (S2, S3) according to any of claims 1 to 6, **characterized in that** said structure (S2, S3) is symmetrical with respect to a plane (F4) perpendicular to the front (F1) and rear (F2) faces and to the plane of the substrate (1).

8. A peripheral structure (S2, S3) according to any of claims 1 to 7, **characterized in that** it comprises field oxides (12, 22) respectively covering the front (F1) and rear (F2) faces in zones excluding the first and second junctions (13, 23) and including the said insulating box (2), said field oxides (12, 22) being arranged between the rear face (F2) and the rear field plate (5,7) and between the front face (F1) and a front field plate (6) according to claim 3 if provided, respectively.

## Patentansprüche

1. Periphere Struktur (S2, S3) für ein monolithisches Leistungsbauelement, umfassend:
- ein Substrat (1) mit einem ersten Dotierungstyp (N),
- eine vordere Seite (F1), welche mit einer Verbindung (10) zu einer Kathode versehen ist,
- eine hintere Seite (F2), welche mit einer Verbindung (20) zu einer Anode versehen ist,
- einen ersten Übergang (13), welcher an eine der Seiten (F1) angrenzt, wobei der erste Übergang (13) in Gegenrichtung polarisiert ist, wenn eine Vorwärtsspannung zwischen der Anode und der Kathode angelegt ist,
- einen zweiten Übergang (23), welcher an die Seite (F2) angrenzt, welche der dem ersten Übergang (13) entsprechenden Seite (F2) gegenüberliegt, wobei der zweite Übergang (23) in Vorwärtsrichtung polarisiert ist, wenn eine Vorwärtsspannung zwischen der Anode und der Kathode angelegt ist, und
- wenigstens einen Isolationskasten (2) mit einem zweiten Dotiertyp (P), welcher die vordere (F2) und hintere (F2) Seite an einem Ende dieser Seiten verbindet und elektrisch von dem ersten Übergang getrennt ist,
- wobei der Isolationskasten (2) von dem zweiten Übergang (23) elektrisch getrennt ist,
- wobei der Isolationskasten (2) gebildet ist durch eine vertikale Isolationswand (2) mit starker Dotierung,
- wobei die Struktur (S2, S3) zwei Implantationszonen (16, 26) mit geringer Dosis des zweiten Dotiertyps (P) umfasst, wobei jede Implantationszone (16, 26) benachbart zu der Wand (2) und einer entsprechenden der vorderen Seite (F1) und hinteren Seite (F2) ist und zwischen der Wand (2) und einem von dem ersten und zweiten Übergang (13, 23) angeordnet ist,
- wobei der erste und zweite Übergang (13, 23), der Isolationskasten (2) sowie die Implantationszonen (16, 26) in einer symmetrischen Konfiguration bezüglich einer Ebene (3) sind, welche parallel zu der vorderen Seite (F1) und hinteren Seite (F2) und beim halben Abstand der Seiten ist,
- wobei die Struktur (S2, S3) eine hintere Feldplatte (5, 7) umfasst, welche die gesamte hintere Seite (F2) bedeckt.

2. Periphere Struktur (32, S3) nach Anspruch 1, **dadurch gekennzeichnet, dass** sie umfasst:
- wenigstens eine erste Implanatationszone (15) mit geringer Dosis des zweiten Dotiertyps (P), welche benachbart zu dem ersten Übergang (13) und der entsprechenden Seite (F1) ist und zwischen dem ersten Übergang (13) und der Wand (2) angeordnet ist,
- wenigstens eine zweite Implantationszone (25) mit geringer Dosis des zweiten Dotiertyps (P), welche benachbart zu dem zweiten Übergang (23) und der entsprechenden Seite (F2) ist und zwischen dem zweiten Übergang (23) und der Wand (2) angeordnet ist.

3. Periphere Struktur (S3) nach Anspruch 2, **dadurch gekennzeichnet, dass** sie umfasst:
- eine vordere Feldplatte (6), welche teilweise die vordere Seite (F1) zwischen der Verbindung (10) zu der Kathode und der Implantationszone (16), welche benachbart zu der Wand (2) und der vorderen Seite (F1) ist, bedeckt.

4. Periphere Struktur (S2, S3) nach einem der Ansprüche 2 oder 3, **dadurch gekennzeichnet, dass** die Implantationszonen (15, 25) mit geringer Dosis, welche benachbart zu dem ersten und zweiten Übergang (13, 23) sind, vom Junction-Termination-Typ sind.

5. Periphere Struktur (S2, S3) nach einem der Ansprüche 1 bis 4, **dadurch gekennzeichnet, dass** die Struktur (S2, S3) vom planaren Typ ist.

6. Periphere Struktur (S2, S3) nach einem der Ansprüche 1 bis 5, **dadurch gekennzeichnet, dass** der erste Dotiertyp N ist und der zweite Dotiertyp P ist.

7. Periphere Struktur (S2, S3) nach einem der Ansprüche 1 bis 6, **dadurch gekennzeichnet, dass** die Struktur (S2, S3) symmetrisch bezüglich einer Ebene (F4) ist, welche senkrecht zu der vorderen Seite (F1) und hinteren Seite (F2) und zu der Ebene des Substrats (1) ist.

8. Periphere Struktur (S2, S3) nach einem der Ansprüche 1. bis 7, **dadurch gekennzeichnet, dass** sie Feldoxide (12, 22) umfasst, welche jeweils die vordere Seite (F1) und hintere Seite (F2) in Zonen bedecken, welche den ersten und zweiten Übergang (13, 23) ausschließen und den Isolationskasten (2) einschließen, wobei die Feldoxide (12, 22) zwischen der hinteren Seite (F2) und der hinteren Feldplatte (5, 7) bzw. zwischen der vorderen Seite (F1) und einer vorderen Feldplatte (6) nach Anspruch 3 eingefügt sind, wenn diese vorgesehen ist.
